Europäisches Patentamt

European Patent Office

Office européen des brevets

(11) Publication number: **0 449 085 A1**

# EUROPEAN PATENT APPLICATION

(21) Application number: **91104220.8**

(51) Int. Cl.⁵: **H05K 13/00**

(22) Date of filing: **19.03.91**

(30) Priority: **30.03.90 IT 4571790**

(43) Date of publication of application:
**02.10.91 Bulletin 91/40**

(84) Designated Contracting States:
**AT BE CH DE ES FR GB LI NL SE**

(71) Applicant: **Casonato, Aldo**
**via Vittorio Veneto 9/B**
**I-31040 Fossalta Maggiore di**

**Chiarano-Treviso(IT)**

(72) Inventor: **Casonato, Aldo**
**via Vittorio Veneto 9/B**
**I-31040 Fossalta Maggiore di**
**Chiarano-Treviso(IT)**

(74) Representative: **Dalla Rosa, Adriano et al**
**PROPRIA Srl Via Mazzini 13**
**I-33170 Pordenone(IT)**

(54) **Modular frame for supporting electronic printed circuits.**

(57) Modular frame for supporting electronic printed circuits utilizable generally on electronic apparatus.

Frame comprising a plurality of metallic sections (8,9,10,11) disposed parallel and reciprocally connected by means of metallic side rods (12,13), on which the sections (8,9,10) may slide longitudinally so as to define correspondent interspaces of variable size between a section and the other one, for supporting such printed circuits.

Frame comprising also a plurality of metallic flat plates (37) insertable into correspondent longitudinal slots (31,32,35,36), provided on the lower part of said sections and so shaped as to present horizontal flat surfaces (41) for supporting the edges of the printed circuits.

This frame also comprises a suitable mechanism adapted to lock or unlock the sections (8,9) with respect to the side rods (12,13), so as to prevent or permit respectively the sliding of the same sections on such side rods (12,13).

The thus constituted frame allows to assemble and disassemble rapidly the printed circuits with respect thereto, as well as the automatized carrying out as much as ever of all the conventional working and cleaning steps foreseen for assembling the component parts on the printed circuits.

FIG. 1

EP 0 449 085 A1

The present invention relates to a modular frame of simple construction for supporting electronic printed circuits of variable sizes, adapted to allow in a rapid and automatized manner all the assembling operations of the component parts on the printed circuits.

At present, the assembling of mass production of the component parts on the electronic printed circuits utilized for the radio-TV sets, the radio alarm clocks and generally the electronic apparatus, is effected by utilizing adequate modular frames with variable sizes, predisposed for supporting a plurality of printed circuits with sizes identical and/or different to each other and adapted to transport contemporaneously all the printed circuits together with the associated included electronic component parts through the different manufacturing stations, where the rheophores of the electronic components parts assembled to the printed circuits are welded by means of tin-lead alloys and afterwards the part in excess of the rheophores is cut by means of adequate tools made of hard materials, so as to obtain cards with pre-established lenght of the rheophores, and finally the thus worked cards are submitted to a cleaning with water or particular chemical detergents, such as for instance the chlorofluorocarbides, for removal of all the exceeding materials and perfectly cleaning the outer surfaces of the printed circuits of said cards.

Modular frames for supporting electronic printed circuits are known, substantially comprising a series of metallic rectilinear sections disposed parallel and spaced as well as interconnected to each other by two metallic side sections, on which said rectilinear sections may slide in order to be shifted in different positions. Besides, such rectilinear sections are provided for the entire lenght thereof with a plurality of flexible support elements with limited width, which are fixed at their one end to the upper part of each section, in such a manner as to be arranged reciprocally adjacent and aligned and whose other end is adequately shaped to form support surfaces. In accordance to a preferred embodiment thereof, each modular frame is constituted by three rectilinear sections and two side sections for sliding the rectilinear sections in different positions, so as to define correspondent interspaces between a rectilinear section and the other one, in which respective printed circuits are introduced, on which the various electronic component parts are then assembled, and which circuits are slidably resting with their side edges on the support surfaces of the flexible support elements fixed to each section. Afterwards, when all the printed circuits have been assembled to the associated modular frame, all the sections are locked in position by acting on suitable conventional fixing means provided for this purpose (screws, bolts etc..), so that the frame is stiffened and thus does not permit undesired displacements of the printed circuits from their assembling position, in order to allow the satisfactory carrying out of the different above described working steps of said circuits. However, in practice these modular frames do not lend themselves in wide limits to the automatized workings of the printed circuits, as on the contrary it would be desirable for reasons of productive efficiency and rationalisation, since in this case when the frames are equipped for the assembling of the printed circuits it is necessary to fix in position in advance the elastic support elements for supporting such circuits with an accurate positioning thereof, to ensure a perfectly horizontal support of the same circuits so that their surfaces may be worked with an extreme accuracy, and such an accurate positioning may be prejudiced in case the elastic support elements are fixed in position inadvertently in an uncorrect manner, with consequent impossibility of satisfactory and reliable carrying out of the different working steps foreseen for the assembled printed circuits. Therefore, at present after that the different weldings provided for the electronic component parts of the printed circuits have been obtained, it is required the disassembling of each frame for the extraction of the printed circuits therefrom and for carrying out the subsequent cut of the rheophores in excess of such circuits, by arranging these latter on proper working equipments foreseen for this purpose. Then, after this working step the printed circuits are re-assembled on the associated frame, which is afterwards automatically transported through suitable conveyors of conventional kind toward the subsequent cleaning station of the same circuits.

Consequently, these working steps also require disassembling and re-assembling operations of the printed circuits with respect to the relevant modular frames, thus are complicated and burdensome from the productive point of view.

Furthermore, modular frames for assembling of electronic printed circuits are known, which are constructively similar to those above described however are unprovided with the elastic support elements for supporting the printed circuits, whose function therefore is performed by a plurality of metallic flat blades which are screwed under the lower surface of each section of said frame, with the eventual interposition of a plastics material with lower thermal conductivity between each blade and said lower surface of the sections, in order to reduce the heat transmission between the metallic blades and the sections, so as to avoid undesired thermal expansions of such blades which would vary the flatness thereof thus making difficult the working of the printed circuits for the same previously cited grounds.

However, these modular frames too are not satisfactory in use because of the complicated construction thereof and of the difficult elimination of the heat which is inevitably trasmitted to such sections through the large surfaces of contact among them and the blades.

Therefore, the scope of the present invention is to eliminate the above described inconveniences and limits, by means of a modular frame for supporting electronic printed circuits having a simple construction and which is obtained for permitting as much as ever the automatized carrying out of all the assembling operations of the component parts onto said circuits, for obtaining thereof in an extremely reliable and productively convenient manner. This modular frame is obtained with the constructive features substantially described with particular reference to the attached claims of the present patent.

The invention will appear more evident from the following description, given solely by way of a non limitative example thereof and with reference to the accompanying drawings, wherein :

- Fig. 1 schematically shows a plan view of the modular frame according to the invention ;
- Fig. 2 shows a side view of the frame of Fig. 1, cutaway along the line A-A ;
- Figs. 3 and 4 show a constructive item of the modular frame of Fig. 1, respectively in a plan view and a side view ;
- Fig. 5 shows a plan view of the frame of Fig. 2, partially cutaway along the line B-B and shifted in a first operative position thereof ;
- Fig. 6 shows a plan view of the frame of Fig. 2, partially cutaway along the line B-B and shifted in a second operative position thereof.

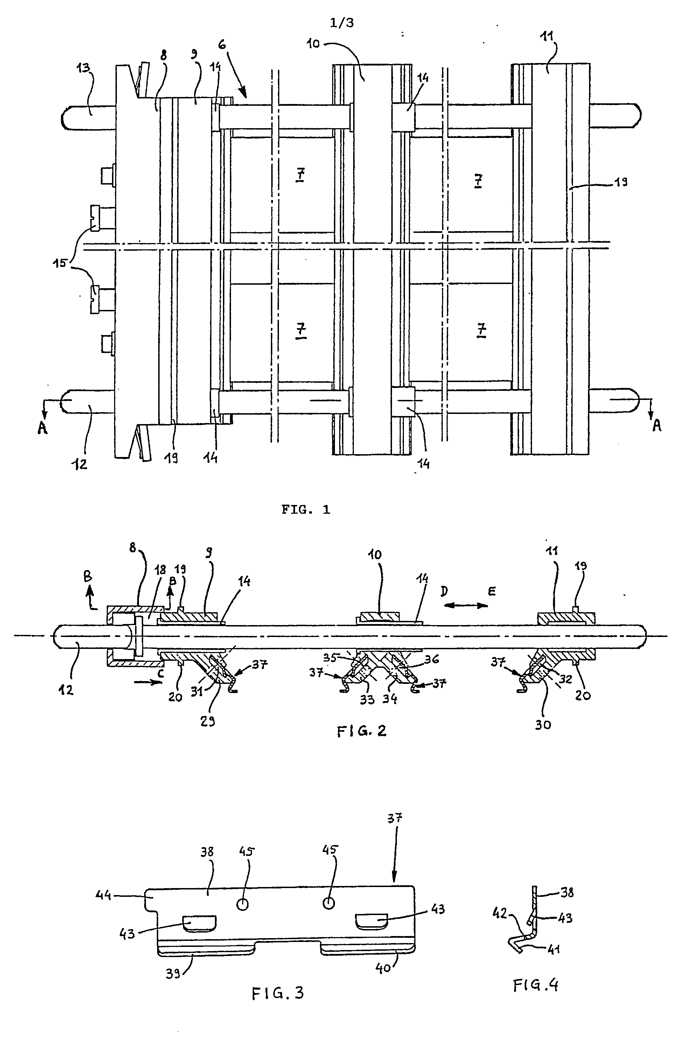

With reference to Fig. 1, it is shown the present modular frame 6 for supporting a plurality of electronic printed circuits 7 utilizable for various applications, such as for instance for the radio-TV sets, the videorecorders, the radio-alarm clocks and generally the electronic apparatus, to permit the automatized carrying out as much as ever of all the working steps normally foreseen and subsequent to the manual assembling of the electronic component parts on the printed circuits, that is weldings of the rheophores of the different electronic component parts assembled to such printed circuits, effected by utilizing tin-lead alloys which are melted in advance into equipments of conventional kind and afterwards the superficial cut of the parts in excess of the reophores, effected through particular tools made of hard metals for obtaining printed circuits with pre-established lenght of the rheophores, which is followed by the cleaning of all the printed circuits with water or particular liquids, such i.e. the chlorofluorocarbides, for the perfect cleaning of the same circuits. In particular, this modular frame substantially comprises a plurality of sections made of aluminium or similar light material, in the present case constituted by four sections 8,9,10 and 11 of the same lenght disposed parallel to each other as well as comprises two side rods 12 and 13 or provided with other suitable geometrical shape, introduced through a series of bushes 14 made of rigid plastics material, inserted through correspondent holes provided transversally to all the cited sections.

As particularly pointed out in Figs. 2, 5 and 6, two of such sections, in this case the sections 8 and 9, are reciprocally approached for the entire lenght thereof and are also joined together by means of devices like screw 15-threaded insert 16, or similar connecting means, with the interposition of at least a compression spring 17 wound around the associated screw and abutting with its ends on the associated opposite walls of such sections. Moreover, these sections have such a shape as to be adaptable the one on the other one, in this case the section 9 is adaptable for its entire lenght in the correspondent cavity 18 of the adjacent "U" shaped section 8, in which it may partially penetrate until the upper 19 and lower longitudinal ribs 20 of said section bear against the opposite surface of the flanges of the "U" shaped section 8, said section 9 being also urged in the direction shown by the arrow C by the action of each spring 17, in such a manner as to be shifted from the cavity 18 of the remaining section 8. In turn, the other sections 10 and 11 of the present modular frame are respectively freely slidable along the rods 12 and 13 as well as fixed to the same rods near their ends by means of conventional fixing means. Besides, the section 11 is also provided with upper 19 and lower longitudinal ribs 20 to make easier the support of the frame on a working surface during assembling and disassembling of the same frame. In this way, printed circuits 7 of different sizes may be introduced in the interspaces defined between the sections 9 and 10 and the sections 10 and 11, thanks to the possibility to vary the width of the interspaces between such sections by adequately shifting the intermediate section 10 along the rods 12 and 13, in the two opposite directions shown by the arrows D and E, which shifting may be effected by acting on a particular mechanism hereinafter described, and such printed circuits are then supported by the associated sections in the manners which will be described later. In addition, when the present modular frame is assembled with the associated printed circuits 7, all the ends of the rods 12 and 13 are protruded beyond the sections adjacent thereto, so that the frame may be automatically lifted and lowered as well as transported by the proper conveyor belts of the working plant (not shown) through the different working stations of the same plant, by acting against the projected ends of such rods 12 and 13.

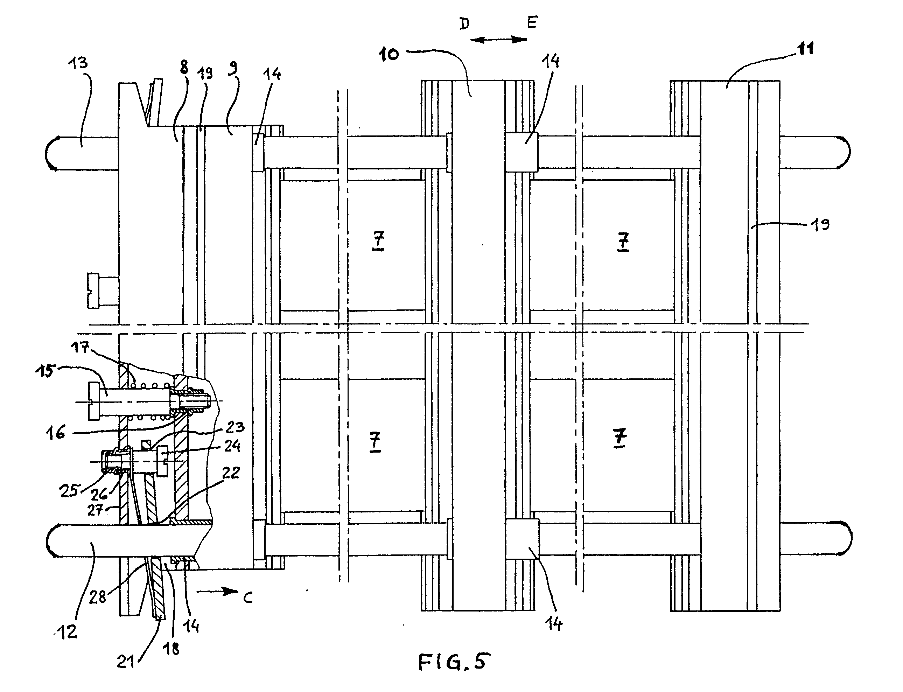

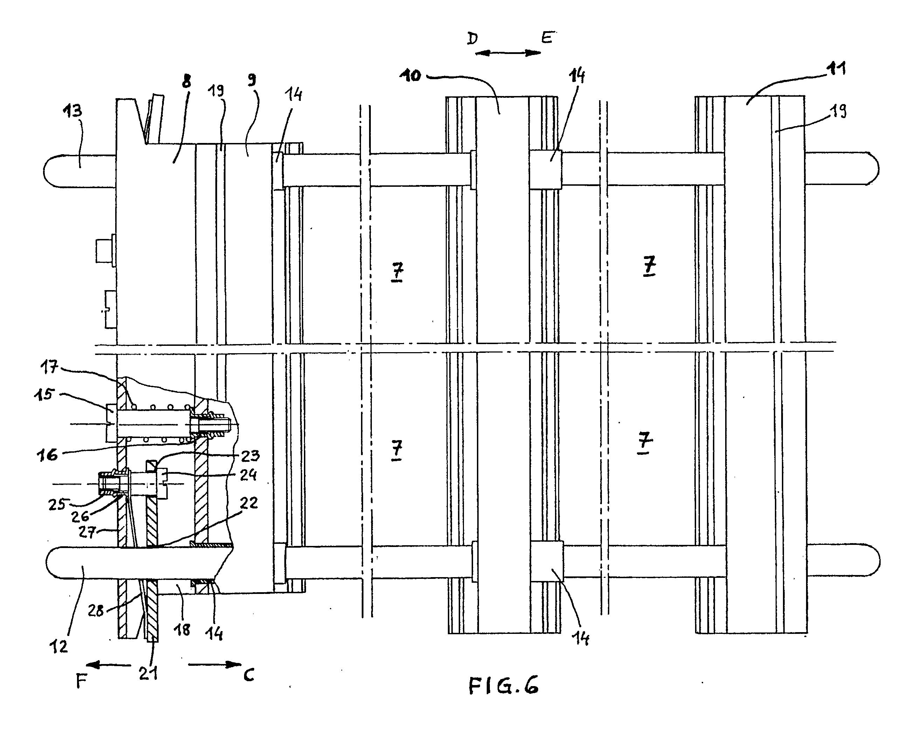

Now, let's describe the mechanism provided for permitting or preventing the sliding of the sections 8,9 and 10 along the side rods 12 and 13 for the specified scopes, with particular reference to Figs. 5 and 6 wherein the modular frame 6 is represented, respectively arranged for working the printed circuits and during the step of disassembling of such circuits from the same frame. In particular, such mechanism substantially comprises at least a metallic blade 21 of limited lenght provided with two through holes 22 and 23, central and lateral respectively, of which the central hole 22 is provided with such a diameter as to permit the one of the rods 12 or 13 to be inserted therethrough, and the side hole 23 permits the passage of a screw 24 screwable in a correspondent threaded insert 25 housed in a hole 26 of the wall 27 of the section 8, thus fixing against such wall 27 both the relevant end of the blade 21 and at least the end of a preloaded plane spring 28, interposed between the wall 27 and the blade 21. As depicted in Figs. 5 and 6, the other end of the plane spring 28 is disposed against the blade 21 and urges thereof to be shifted in the inclined position shown in the Fig. 5, in which the circular edge of the central through hole 22 comes in contact to the outer surface of the rod (in this case of the rod 12), thus locking in position the two sections 8 and 9 and preventing any longitudinal sliding thereof on both rods 12 and 13. In order to be able to perform such sliding, to dispose on or remove the printed circuits 7 from the relevant support positions between the different sections, as pointed out in Fig. 6, it is sufficient to push the free end of the blade 21 in the direction F, against the action of the plane spring 28, by shifting in this way said blade in the vertical direction so that the circular edge of the central through hole 22 of the same blade is shifted from the outer surface of the rod 12 and is not more in contact to such surface, thus permitting the considered sliding. Therefore, this mechanism of control of sliding of the sections 8,9 and 10 on the rods 12 and 13 is of simple construction and permits to effect or prevent such sliding with a sole manoeuvre on the blade 21.

Examining now Fig. 2, it is shown the manner in which the printed circuits 7 are supported by the sections 9,10 and 11 of the present modular frame. As it is apparent, each of the sections 9,10 and 11 is adequately shaped on its lower part and in particular the extreme sections 9 and 11 have lower rectilinear longitudinal portions 29 and 30 inclined simmetrically convergent to each other, in which respective longitudinal slots 31 and 32 are provided, having an almost rectangular profile which is tapered toward its upper part.

In turn, the intermediate section 10 has two lower longitudinal and rectilinear portions 33 and 34, inclined simmetrically diverging to each other, in which respective longitudinal slots 35 and 36 having the same profile of the preceding slots are provided, said longitudinal portions 33 and 34 being inclined in a simmetrically convergent manner with respect to the opposite longitudinal portions 29 and 30 of the associated sections 9 and 11.

The scope of the longitudinal slots of all the sections is that to act as guide members for sliding of a plurality of metallic plates 37, shaped and adapted to support the relevant longitudinal edges of the printed circuits 7 in the manner hereinafter described. As it is particularly apparent in Figs. 3 and 4, each plate 37 is substantially constituted by a flat surface 38 of almost rectangular form and reduced thickness, slidably adaptable in the longitudinal slots of the considered sections, surface whose front edge is so shaped as to form two identical edge portions 39 and 40, aligned and spaced to each other, each of them is so bent as to present a short horizontal flat surface 41 acting as a support surface for the longitudinal edges of the printed circuits 7 and which is joined with a reduced bending radius to another surface 42, inclined at an acute angle with respect to such horizontal flat surface, said further surface in turn being joined almost orthogonally with respect to the flat surface 38 of the present plate. Moreover, such flat surface 38 is provided with two identical tongues 43 of limited sizes, obtained by punching in a position below the same surface and inclined toward the edge portions 39,40 of the plate referred to, which tongues engage the walls of the associated slot in which each plate 37 is inserted, thus avoiding any displacement, also minimum, of the same plate due to the weight of the printed circuits being supported on its horizontal flat surfaces 41 and therefore permitting to maintain perfectly horizontal said printed circuits for the automatized carrying out of all the above indicated working steps. In practice, various metallic plates 37 of small sizes are inserted through each slot of the different sections of the present support frame, which plates are reciprocally approached with a respective projection 44 provided sidewise at the flat surface 38, thus constituting a non continuous flat surface for supporting the printed circuits in the cited manner, which circumstance causes a smaller contact surface between each section and the plates inserted in its slots and therefore a lesser heat transmission from said plates toward said sections, with consequent thermal expansions almost of no value of the plates and of the same sections.

Finally, the flat surface 38 of each plate 37 is also provided with two through holes 45, to permit the removable connection in position thereof by per se known means.

The so obtained modular frame is of simple construction and permits the rapid assembling and disassembling of the printed circuits with few manoeuvres with respect thereto and, thanks to the presence of the metallic plates 37 shaped and fitted on the same frame in the above specified way, it is able to maintain perfectly horizontal such circuits during the course of the different working steps thereof, which therefore are performed in an almost automatized manner by means of conventional working and transport plants, with a consequent high productive efficiency and rationalization of these products.

## Claims

1. Modular frame for supporting a plurality of electronic printed circuits of variable sizes generally for electronic apparatus, adapted to be worked and cleaned in per se known manner and with per se known appliances, the frame including at least a first, a second and a third metallic section disposed preferably parallel and spaced to each other in a different manner depending on the sizes of the printed circuits, as well as interconnected to each other by means of at least two metallic side sections preferably shaped as rectilinear rods, inserted through associated rigid bushes introduced through correspondent through holes of said sections, the frame being characterized in that it comprises rigid support means (37) associated to said first, second and third section (9,10,11) and adapted to support said printed circuits (7) as well as locking means (21,28) co-operating with at least one of said side sections (12,13), in such a manner as to prevent or permit respectively the sliding of said sections on said side sections.

2. Modular frame according to claim 1, characterized in that said support means comprise a plurality of metallic plates (37) insertable in a reciprocally approached position into inclined longitudinal slots (31;33,34;32), provided on the respective lower part of said first, second and third section (9,10,11).

3. Modular frame according to claim 2, characterized in that each metallic plate (37) comprises a horizontal flat surface (38) provided with at least a side projection (44), adaptable within each of said slots (31;33,34;32) and provided with inclined tongues (43) or the like, to engage the correspondent walls of the same slots as well as with through holes (45) for fixing in position said plate (37) by per se known means, said flat surface (38) being provided along its front edge with edge portions (39,40) reciprocally spaced and respectively joined to further horizontal flat surfaces (41) for supporting the edges of said printed circuits (7) and inclined preferably at an acute angle with respect to said flat surface (38).

4. Modular frame according to claim 1, characterized in that said locking means comprise a metallic blade (21) joined at one end thereof, together with at least a preloaded plane spring (28) or similar resilient element, to the correspondent wall of a further section (8) disposed parallel and adaptable as well as reciprocally connected to said first section (9) by means of sprung means (15,16,17), said metallic blade (21) being provided with a through hole (22) slidably insertable on at least one of said side sections (12,13) and being shiftable from a locked position, in which it is urged by said plane spring (28) to be disposed in an inclined position with respectt to the associated side section (12,13), by preventing the sliding on said side sections (12,13), to an unlocked position in which it is disposed vertically to the associated side section (12,13), by permitting such sliding.

5. Modular frame according to claim 4, characterized in that said sprung means comprise a compression spring (17) wound around a screw (15) engaging a threaded insert (16) and abutting at its ends on the relevant opposite walls of said first and said further section (9,8).

1/3

FIG. 1

FIG. 2

FIG. 3

FIG. 4

FIG.5

FIG.6

# EUROPEAN SEARCH REPORT

**EP 91 10 4220**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | FR-A-2 495 884 (LIGNES TELEGRAPHIQUES ET TELEPHONIQUES) <br> * page 6, lines 9 - 23 * | 1-2 | H 05 K 13/00 |
| A | US-A-3 043 587 (DENTON W. UNDERHILL) <br> * column 2, line 57 - column 3, line 22 * | 1 | |
| A | CA-A-1 240 405 (NORTHERN TELECOM LIMITED) <br> * page 3, lines 14 - 25 * | 3 | |

|  | TECHNICAL FIELDS SEARCHED (Int. Cl.5) |
|---|---|
|  | H 05 K |

The present search report has been drawn up for all claims

| Place of search | Date of completion of search | Examiner |
|---|---|---|
| The Hague | 17 May 91 | TOUSSAINT F.M.A. |